**Europäisches Patentamt**

**European Patent Office**

**Office européen des brevets**

(19)

(11) Veröffentlichungsnummer: **0 228 394 B1**

# (12) EUROPÄISCHE PATENTSCHRIFT

(45) Veröffentlichungstag der Patentschrift:
**10.04.91 Patentblatt 91/15**

(51) Int. Cl.⁵: **C23C 16/50**, C23C 16/54, H01J 37/32, B05D 1/00

(21) Anmeldenummer: **86903363.9**

(22) Anmeldetag: **04.06.86**

(86) Internationale Anmeldenummer:
**PCT/EP86/00332**

(87) Internationale Veröffentlichungsnummer:
**WO 86/07391 18.12.86 Gazette 86/27**

(54) VERFAHREN UND VORRICHTUNG ZUM BESCHICHTEN VON SUBSTRATEN MITTELS EINER PLASMAENTLADUNG.

(30) Priorität: **14.06.85 DE 3521318**

(43) Veröffentlichungstag der Anmeldung:
**15.07.87 Patentblatt 87/29**

(45) Bekanntmachung des Hinweises auf die Patenterteilung:
**10.04.91 Patentblatt 91/15**

(84) Benannte Vertragsstaaten:
**AT BE CH DE FR GB IT LI LU NL SE**

(56) Entgegenhaltungen:
US-A- 3 536 602
US-A- 4 422 896

(73) Patentinhaber: **LEYBOLD AKTIENGESELLSCHAFT**
**Wilhelm-Rohn-Strasse 25**
**W-6450 Hanau am Main 1 (DE)**

(72) Erfinder: **HARTIG, Klaus**
**Hanauer Strasse 17**
**W-6451 Ronneburg 1 (DE)**
Erfinder: **DIETRICH, Anton**
**Heilbrunn 16**
**W-8441 Wiesenfelden (DE)**

(74) Vertreter: **Zapfe, Hans, Dipl.-Ing.**
**Am Eichwald 7**
**W-6056 Heusenstamm 2 Rembrücken (DE)**

**Beschreibung**

Die Erfindung betrifft ein Verfahren zum Beschichten von kontinuierlich über eine Elektrode bewegten Substraten durch Abscheidung von Verbindungen aus der Gasphase mittels einer durch die Elektrode erzeugten Plasmaentladung mit einer chemischen Reaktion, wobei auf der dem Substrat abgekehrten Seite der Elektrode ein Magnetsystem zur Erzeugung einer das Plasma einschnürenden magnetischen Falle angeordnet ist.

Durch die US-A-4 422 896 sind ein Verfahren und eine Vorrichtung zum Ätzen von Substraten bekannt, bei denen über den Substraten eine magnetische Falle angeordnet ist, durch die das Ätzplasma auf die Substratoberfläche konzentriert wird.

Bei der bekannten Lösung dient die magnetische Falle nicht dazu, die Beschichtung in Substratnähe zu intensivieren, sondern dazu die Ätzwirkung zu verstärken. Mit anderen Worten, es muß dafür Sorge getragen werden, daß ein möglichst großer Anteil der von den Substraten abgestäubten Partikel den Bereich der magnetischen Falle verläßt.

Ein Einsatzgebiet für das eingangs beschriebene Verfahren ist die Beschichtung von Folien mit Polymerisaten, die aus polymerisationsfähigen Monomeren aus der Gasphase niedergeschlagen werden. Hierzu ist es erforderlich, dem Plasma bzw. der Glimmentladung entsprechende reaktionsfähige Monomere zuzuführen. Ein weiteres Einsatzgebiet ist die Abscheidung aus anorganischen Verbindungen.

Durch die DE-OS 26 08 415 ist ein Beschichtungsverfahren der eingangs beschriebenen Gattung bekannt, mit dem beispielsweise Schichten aus Polystyrol erzeugt werden sollen. Dabei liegen einander zwei Elektroden im Abstand von etwa 4 cm in paralleler Lage gegenüber, und das Substrat wird in der Mitte zwischen diesen Elektroden hindurchgeführt. Auf der der Substratposition jeweils abgekehrten Seite einer jeden Elektrode befindet sich ein Magnetsystem zur Erzeugung einer das Plasma einschnürenden magnetischen Falle. Das Plasma brennt dabei in unmittelbarer Nähe einer jeden Elektrodenoberfläche und in einiger Entfernung vom Substrat, so daß Polymerisat auf den Elektrodenoberflächen abgeschieden wird. Es wird auch von der Beobachtung berichtet, daß die Katodenzerstäubungsrate des Elektrodenmaterials viel kleiner ist als diejenige des auf der Elektrode abgelagerten Materials. Das bekannte Verfahren beruht auf der Hoffnung, das Polymerisat aus der Gasphase zunächst auf den Elektroden zu erzeugen und von dort in Richtung auf das Substrat wieder abzustäuben. Das Eintreten des beschriebenen Effektes beruht auf der Tatsache, daß ein Plasma **zwischen** der jeweils zu beschichtenden Substratoberfläche und der dieser Oberfläche zugekehrten Elektrode aufrechterhalten wird, und dies ist wiederum nur möglich, weil der Abstand zwischen der Substrat- und der Elektrodenoberfläche um ein Vielfaches größer ist als der unter den gegebenen Verfahrensbedingungen sich einstellende Dunkelraumabstand. Der tatsächlich vorhandene Abstand liegt – unter Vernachlässigung der Substratdicke – bei etwa 20 mm, während der sich unter den Verfahrensbedingungen einstellende Dunkelraumabstand maximal in der Größenordnung von etwa 3 mm liegt. Bei dem bekannten Verfahren werden aber nicht nur die Elektroden, sondern auch weitere Teile der Inneneinrichtung der evakuierbaren Reaktionskammer beschichtet und verschmutzt.

Durch den Aufsatz von Morosoff/Newton/Yasuda "Plasma polymerization of ehtylene by magnetron discharge", veröffentlicht in J.Vac.Sci.Technol., 15 (6), Nov./Dec. 1978, Seiten 1815 bis 1822, sind ein ganz ähnliches Verfahren und eine Vorrichtung bekannt, bei dem der lichte Abstand der Elektrodenplatten 7,6 cm beträgt. Es geht auch hier darum, dem plasma Monomerdämpfe zuzuführen, die sich auf dem Substrat als polymerisate niederschlagen. Auf hierbei geht es darum, das Polymerisat zunächst auf den aus Aluminium bestehenden Elektrodenplatten niederzuschlagen, und erst von dort in Richtung auf das Substrat abzustäuben.

Durch den Aufsatz von Kaganowicz/Ban/Robinson "Spatial Effects in Plasma Deposition of SiO$_x$ Using Magnetically Enhanced Glow Discharge", veröffentlich in ISPC-6 Montreal, Juli 1983, Nummer C-7-6 sind ein wiederum vergleichbares Verfahren und eine Vorrichtung zur Erzeugung von Silan-Schichten aus Siliziumverbindungen bekannt. Bei der dort beschriebenen Vorrichtung liegen sich zwei Magnetronkatoden gleichfalls spiegelsymmetrisch gegenüber, und der lichte Abstand der Elektrodenplatten beträgt 5 cm. Die Verfasser berichten über die Beobachtung, daß die Schichtzusammensetzung sehr stark von der räumlichen Entfernung von den Elektroden abhängig ist und daß sich sogar Schichtmaterial in der Nähe des Ausgangs der Reaktionskammer weit entfernt von den Elektroden niederschlägt. Die Abhängigkeit der Schichtzusammensetzung von der Entfernung von den Elektroden hat insbesondere bei bewegten Substraten, die kontinuierlich zwischen den Elektroden hindurchgeführt werden, den Nachteil, daß erheblich inhomogene Schichten entstehen. Man muß sich hierbei vergegenwärtigen, daß der Schichtaufbau mit geringer Niederschlagsrate bereits in einiger Entfernung von dem Spalt zwischen den Elektroden beginnt, daß die Niederschlagsrate beim Durchlauf des Substrats durch den besagten Spalt ein Maximum durchläuft und daß die Schichtbeschaffenheit und die Niederschlagsrate sich nach dem Austritt aus dem Spalt wieder in umgekehrter Weise verändern, wie vor dem Eintritt in den Spalt.

Beim Schichtaufbau ist aber nicht nur die Schichtzusammensetzung selbst maßgebend, sondern auch der Auftreffwinkel, mit dem die einzelnen Schichtpartikel auf das Substrat auftreffen. So kann beispielsweise bei zahlreichen Beschichtungsprozessen beobachtet werden, daß unter einem schrägen, insbesondere bei unter einem spitzen Winkel stattfindenden Beschichtungsprozessen eine stark verschlechterte Haftung des Schichtmaterials auf dem Substrat auftritt, ein Vorgang, der für die meisten Anwendungsfälle höchst unerwünscht ist.

Der Erfindung liegt daher die Aufgabe zugrunde, ein Beschichtungsverfahren der eingangs beschriebenen Gattung anzugeben, bei die chemische Reaktion auf die unmittelbare Nachbarschaft des Magnetsystems und des Substrats beschränkt ist. Insbesondere soll die Kondensation von Schichtmaterial an von dem Magnetsystem entfernten Stellen verhindert und der Aufbau weitgehend homogener Schichten ermöglicht werden.

Die Lösung der gestellten Aufgabe erfolgt bei dem eingangs beschriebenen Verfahren erfindungsgemäß dadurch, daß die zu behandelnde Oberfläche des Substrats in einem konstanten Abstand "s," von der Elektrode gehalten wird, der **kleiner** ist als der unter den vorgegebenen Verfahrensbedingungen sich einstellende Dunkelraumabstand, und daß die magnetische Falle so eingestellt wird, daß sie das Substrat durchdringt und über der zu beschichtenden Oberfläche des Substrats geschlossen ist, derart, daß die chemische Reaktion im eingeschnürten Plasma auf der zu beschichtenden Oberfläche des Substrats aufrechterhalten wird.

Der wesentliche Unterschied zum Stand der Technik besteht darin, daß das Plasma ausschließlich auf der dem Magnetsystem **gegenüberliegenden** Seite des Substrats brennt (auch wenn das Magnetsystem nur einfach, und nicht spiegelsymmetrisch vorhanden ist). Das Substrat hat dabei von dem Magnetsystem bzw. von der gegebenenfalls zwischen dem Substrat und dem Magnetsystem liegenden, zur Vorrichtung gehörenden Elektrode einen derart geringen Abstand, daß sich an dieser Stelle keine Glimmentladung bzw. keine chemische Reaktion ausbilden kann. Dieser Abstand muß kleiner sein als der sogenannte Dunkelraumabstand, der in der Plasmaphysik hinreichend definiert ist. Er beträgt bei den eingangs beschriebenen Prozeßparametern etwa 1 bis 3 mm und geht in keinem Fall wesentlich über 3 mm hinaus.

Durch die erfindungsgemäße Verfahrensführung wird der Beschichtungsvorgang auf den unmittelbaren Einwirkungsbereich des Plasmas auf das Substrat beschränkt. Dabei findet die Kondensation des Schichtmaterials gleichfalls praktisch ausschließlich im Bereich des Plasmas statt, und insbesondere werden keine Vorrichtungsteile beschichtet. Dadurch wird der Ausnutzungsgrad des in vielen Fällen teuren Beschichtungsmaterials wesentlich verbessert, und die ansonsten notwendige Reinigung der Vorrichtung wird wesentlich eingeschränkt. Durch die Unterdrückung der Beschichtung außerhalb des eigentlichen Entladungsbereichs wird gleichzeitig eine Vorbeschichtung von kontinuierlich der Beschichtungszone zugeführtem Substratmaterial vermieden, so daß ein außerordentlich homogener Schichtaufbau erzielt wird. Insbesondere wird eine schädliche Vorbeschichtung unter spitzem Winkel vermieden.

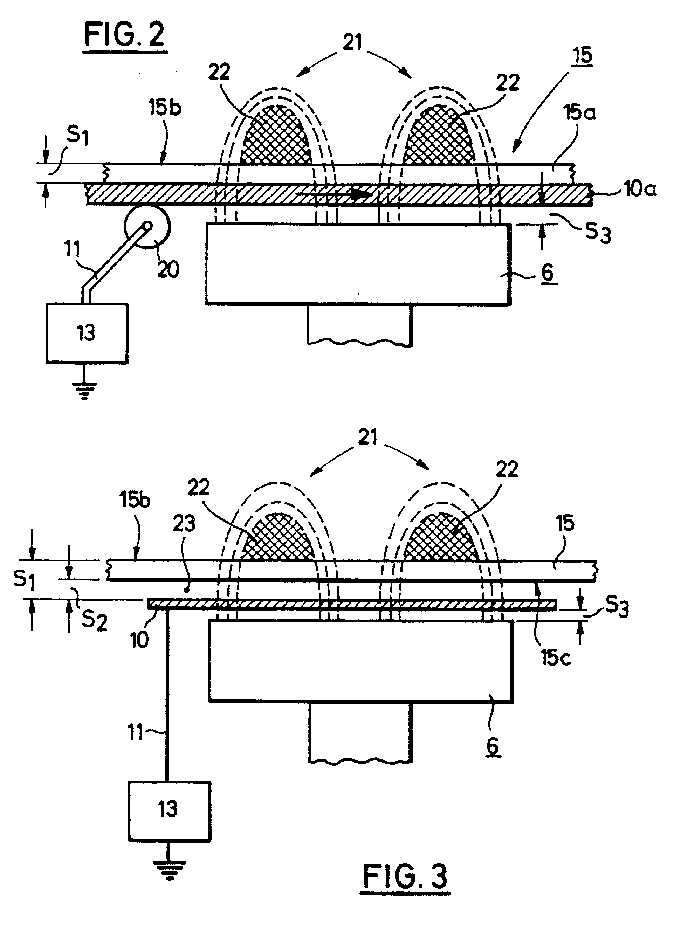

Das Substrat kann dabei aus verschiedenen Materialien bestehen wie beispielsweise aus Metallen, Halbleitern, Isolierstoffen wie Glas, Kunststoff und Keramik. Sofern elektrisch leitendes Substratmaterial zum Einsatz kommt, kann auf eine besondere Elektrode verzichtet werden : In diesem Fall wird das Substrat selbst an eine entsprechende (negative) Spannung gelegt und ist mit der Elektrode identisch. Bei beweglichen Substraten kann dies durch eine Kontaktrolle geschehen (Figur 2). Bei der Behandlung von Substraten aus nichtleitendem Material, wie z.B. bei Kunststoff-Folien, wird eine besondere Elektrode zwischen dem Substrat und dem Magnetsystem angeordnet und mit einer Spannungsquelle verbunden (Fig 3). Die Spannungsquelle ist dabei von solcher Beschaffenheit, daß die Elektrode entweder auf negativem Gleichspannungspotential oder an Hochfrequenz gelegt ist, was bei den üblichen relativen Abmessungen von Elektrode und den übrigen, auf Massepotential liegenden Bauteilen der Reaktionskammer dazu führt, daß die Elektrode eine negative Vorspannung, die sogenannte Bias-Spannung, annimmt. Dabei darf weder der Abstand zwischen der Elektrode. und dem Magnetsystem noch der Abstand zwischen der Elektrode und dem Substrat größer sein als der erwähnte Dunkelraumabstand, so daß in den genannten Zwischenräumen jegliche Glimmentladung vermieden wird.

Es ist dabei auch möglich, die Elektrode baulich und elektrisch leitend mit dem Magnetsystem zu vereinigen, wobei dann lediglich dafür Sorge zu tragen ist, daß die gesamte Anordnung, also einschließlich des Magnetsystems, gegenüber den metallischen Teilen der Reaktionskammer elektrisch isoliert sind.

Bei Verwendung einer ortsfesten, d.h. vom Substrat unabhängigen Elektrode wird in besonders vorteilhafter Weise so verfahren, daß die der Elektrode zugekehrte erste Oberfläche des Substrats in einem Abstand "s₂" zur Elektrode gehalten wird, der kleiner ist als der unter den vorgegebenen Verfahrensbedingungen gegebene Dunkelraumabstand, und daß die magnetische Falle so eingestellt wird, daß sie das Substrat durchdringt und über der der Elektrode abgewandten zweiten Oberfläche des Substrats geschlossen ist, derart, daß die chemische Reaktion im eingeschnürten Plasma auf der der Elektrode abgekehrten Seite des Substrats aufrechterhalten wird (Figur 3).

Mit ganz besonderem Vorteil eignet sich das erfindungs- gemäße Verfahren für die Beschichtung von kontinuierlich über die Elektrode bzw. relativ zum Magnetsystem bewegten Folien, da durch diese Relativbewegung ein außerordentlich gleichförmiger Beschichtungsvorgang – über die Länge des Substrats gesehen – durchgeführt werden kann.

Die Erfindung betrifft auch einen chemischen Reaktor zur Durchführung des vorstehend beschriebenen Verfahrens. Eine solche Vorrichtung besitzt in herkömmlicher Weise eine evakuierbare Reaktionskammer mit mindestens einer Zuführungseinrichtung für die Reaktionskomponenten, eine Haltevorrichtung für mindestens ein Substrat, eine in der Nähe der Substratposition angeordnete Elektrode für die Erzeugung eines Plasmas und ein auf der der Substratposition gegenüberliegenden Seite der Elektrode angeordnetes Magnetsystem mit Polflächen entgegengesetzter Polung zur Erzeugung einer von den Polflächen ausgehenden, in sich geschlossenen, die Elektrode durchdringenden magnetischen Falle.

Zur Lösung der gleichen Aufgabe ist eine solche Vorrichtung erfindungsgemäß dadurch gekennzeichnet, daß die Haltevorrichtung in einer solchen räumlichen Lage zur Elektrode angeordnet ist, daß sich die der Elektrode zugekehrte erste Oberfläche des Substrats in einem Abstand "$s_2$" zur Elektrode befindet, der kleiner ist als der unter den vorgegebene Verfahrensbedingungen gegebene Dunkelraumabstand von etwa 1-3 mm, und daß die magnetische Falle so eingestellt ist, daß sie das Substrat durchdringt und über der der Elektrode abgewandten zweiten Oberfläche des Substrats geschlossen ist, derart, daß sich das eingeschnürte Plasma und die chemische Reaktionszone auf der der Elektrode abgekehrten Seite des Substrats befinden.

Weitere vorteilhafte Ausgestaltungen des Erfindungsgegenstandes ergeben sich aus den übrigen UnteranSprüchen.

Beim Erfindungsgegenstand ist die räumliche Ausdehnung des Plasmas auf die unmittelbare Nachbarschaft der Elektrode bzw. des hinter der Elektrode befindlichen Magnetsystems beschränkt. Dadurch sind die Beschichtungsbedingungen nur in unmittelbarer Nähe des Substratserfüllt. Der für die Beschichtung verwendete Energieanteil kann dabei außerordentlich genau kontrolliert werden, so daß die Niederschlagsraten und die Schichteigenschaften genau und reproduzierbar eingestellt werden können.

Die Beschichtung von Vorrichtungsteilen wird dabei so gut wie vollständig vermieden, so daß es auch nicht zu dem gefürchteten Abplatzen oder Abschälen von Schichtmaterial kommt, das sich im Laufe der Zeit ansonsten auf Vorrichtungsteilen ansammelt und im Falle des Abplatzens zu Betriebsstörungen oder fehlerhaften Schichten führt. Verunreinigungen, die sich auf zu beschichtenden Substraten ablagern, führen zu örtlichen Unterbrechungen der Schicht. Wenn es sichum sehr kleine partikel handelt, treten an den Substraten sogenannte Miniaturlöcher oder "Pin-Holes" auf, die unvermeidbar zu Ausschuß führen.

Beim Erfindungsgegenstand kann weiterhin durch Gasdrutk, relative Lage und Stärke des Magnetfelds sowie durch die elektrische Feldstärke die Konzentration des Plasmas sehr gut eingestellt und definiert werden, wodurch die Reproduzierbarkeit des Verfahrens weiter gefördert wird.

Verfahren und Vorrichtung werden nachfolgend anhand der Figuren 1 bis 5 näher erläutert.

Es zeigen :

Figur 1 einen Vertikalschnitt durch eine Vorrichtung zur Beschichtung einer kontinuierlich bewegten Kunststoff-Folie,

Figur 2 einen Ausschnitt aus Figur 1 in vergrößertem Maßstab mit der Variante, daß auf eine ortsfeste Elektrode verzichtet wird und das leitfähige Substrat selbst die Elektrode bildet,

Figur 3 einen Ausschnitt aus Figur 1 in vergrößertem Maßstab,

Figur 4 einen Vertikalschnitt durch eine Vorrichtung zur Beschichtung einer hohlzylindrischen Walze oder einer über diese Walze geführten Folie und

Figur 5 einen Schritt entlang der Linie V-V durch den Gegenstand von Figur 4.

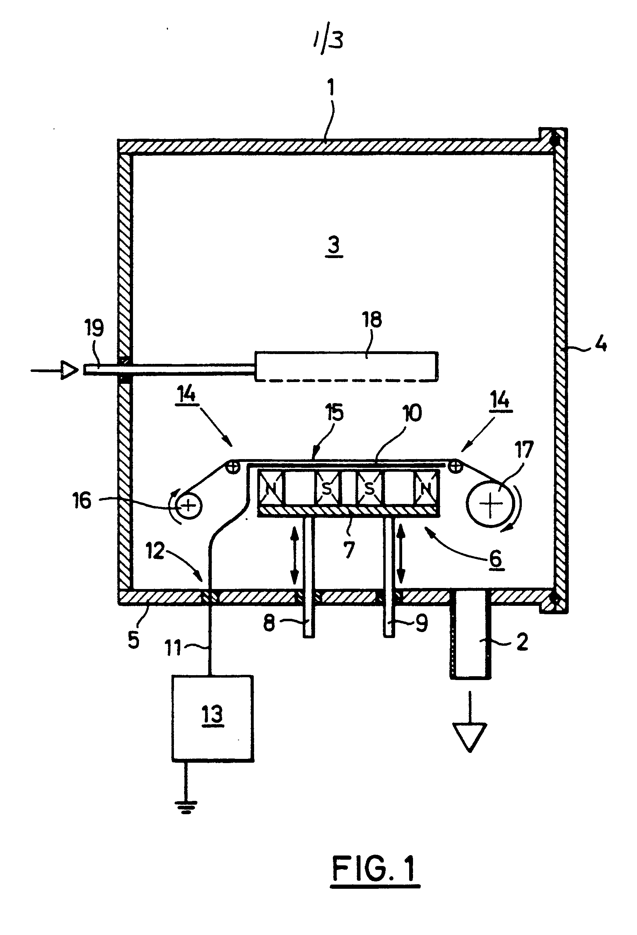

In Figur 1 ist eine Reaktionskammer 1 dargestellt, die über eine Saugleitung 2 an einen nicht dargestellten Satz von Vakuumpumpen anschließbar ist. Der Innenraum 3 der Rekationskammer ist durch eine Tür 4 zugänglich.

Die Reaktionskammer besitzt einen Boden 5, auf dem – in der Höhe verstellbar – ein Magnetsystem 6 befestigt ist. Dieses Magnetsystem besteht aus einer ferromagnetischen Jochplatte 7, auf der zwei in sich geschlossene Reihen von Permanentmagneten angeordnet sind. Die nach oben gerichteten Polflächen dieser Magnete sind entgegengesetzt gepolt, und zwar liegen bei der inneren Reihe der Magnete die Südpole oben, bei der äußeren Reihe von Magneten die Nordpole. Auf diese Weise wird ein oberhalb der Polflächen liegen der geschlossener Tunnel aus Magnetfeldlinien gebildet, wie dies von den sogenannten ZerstäubungsMagnetrons her bekannt ist. Ein derartiges Magnetron ist beispielhaft in der DE-OS 30 47 113 beschrieben, allerdings in umgekehrter Lage zeichnerisch dargestellt. Die Jochplatte 7 ist höhenverstellbar auf Stützen 8 und 9 gelagert, die als Rohre ausgebildet sein können und für die Zu- und Abfuhr von Kühlwasser dienen können.

Unmittelbar oberhalb der Polflächen ist eine plattenförmige Elektrode 10 angeordnet, die sämtliche Polflächen überdeckt und über eine Leitung 11, die über eine Vakuumdurchführung 12 herausgeführt ist, mit einer Spannungsquelle 13 in Verbindung steht. Die Spannungsquelle 13 ist dabei entweder eine Gleichspannungsquelle, an deren negativer Pol die Elektrode 10 gelegt ist, oder eine Hochfrequenzquelle mit einer Frequenz von beispielhaft 13,56 MHz. Eine Versorgung der Elektrode 10 mit Hochfrequenz führt zu einer negativen Vorspannung dieser Elektrode relativ zur Reaktionskammer 1.

Der Elektrode 10 ist eine Haltevorrichtung 14 für ein Substrat 15 zugeordnet, das aus einer Folie besteht. Die Haltevorrichtung wird im vorliegenden Fall durch zwei Führungswalzen gebildet, die das Substrat 15 in einer planparallelen Lage horizontal über die Elektrode 10 führen. Das Substrat 15 wird dabei von einer Vorratsrolle 16 zugeführt und nach der Plasmabehandlung auf einer Aufwickelrolle 17 wieder gesammelt. Oberhalb der Elektrode 10 bzw. oberhalb der durch die Haltevorrichtung 14 definierten Substratposition befindet sich eine Gaszuführungseinrichtung 18, der das erforderliche Reaktionsgas, vorzugsweise im Gemisch mit einem Inertgas wie Argon, über eine Leitung 19 von einem nicht gezeigten Vorratsbehälter zugeführt wird. Die Gaszuführungseinrichtung besitzt eine Vielzahl von Öffnungen, durch die das Gas in großflächiger Verteilung in Richtung des Substrats austreten kann.

In Figur 2 ist eine Anordnung dargestellt, bei der das Substrat 15 selbst aus einem elektrisch leitfähigen Werkstoff (Metall) besteht und infolgedessen die Funktion der Elektrode 10 in Figur 1 übernimmt. Der leitfähige Teil des Substrats 15 ist infolgedessen mit 10a bezeichnet. Diesem leitfähigen Teil wird von der Spannungsquelle 13 her die erforderliche Spannung über eine Kontaktrolle 20 zugeführt. Im vorliegenden Falle ist der leitfähige Teil 10a des Substrats 15 noch mit einem Isolierstoffbelag 15a versehen, der beispielsweise durch eine Isolierstoff-Folie gebildet sein kann, um aufzuzeigen, daß als Substrat 15 auch sogenannte Verbundfolien in Frage kommen.

Die sogenannte "magnetische Falle 21" ist durch gestrichelt angedeutete magnetische Feldlinien dargestellt, das von dieser magnetischen Falle eingeschnürte bzw. eingeschlossene Plasma 22 ist kreuzschraffiert dargestellt. Die zu behandelnde Oberfläche 15b des Substrats 15 ist dem Magnetsystem 6 und dem leitfähigen Teil 10a abgekehrt. Dabei ist der Abstand $S_1$ der zu behandelnden Oberfläche 15b des Substrat von der Elektrode (leitfähiges Teil 10a) kleiner als der unter den vorgegebenen Verfahrensbedingungen sich einstellende Dunkelraumabstand. Im vorliegenden Falle kann sich zwischen der zu beschichtenden Oberfläche 15b und der Elektrode bzw. dem leitfähigen Teil 10a überhaupt keine Glimmentladung ausbilden, weil der Isolierstoffbelag 15a, zu dem die zu beschichtende Oberfläche 15b gehört, in körperlicher Berührung mit dem leitfähigen Teil 10a steht. Es handelt sich mithin um einen Grenzfall.

Ein weiterer Grenzfall ist für den Fall gegeben, daß der Isolierstoffbelag 15a nicht vorhanden ist. In diesem Fall ist der Abstand $s_1 = 0$. Zu beachten ist auch, daß der Abstand $s_3$ zwischen der Rückseite der Elektrode (des leitfähigen Teils 10a) und dem Magnetsystem 6 gleichfalls kleiner sein muß, als der unter den vorgegebenen Verfahrensbedingungen sich einstellende Dunkelraumabstand.

Es ist in Figur 2 aber insbesondere zu erkennen, daß die magnetisrhe Falle so eingestellt ist, daß sie das Substrat 15 durchdringt und über der zu beschichtenden Oberfläche des Substrats geschlossen ist, derart, daß das eingeschnürte Plasma 22 auf der zu beschichtenden, dem Magnetsystem 6 abgekehrten, Oberfläche 15b des Substrats aufrechterhalten wird.

Die Figur 3 zeigt in vergrößertem Maßstab die Verhältnisse im unteren Teil der Vorrichtung nach Figur 1. In diesem Falle ist dem Magnetsystem eine ortsfeste Elektrode 10 zugeordnet, wobei der Abstand $s_3$ zwischen diesen beiden Teilen wiederum kleiner ist als der erwähnte Dunkelraumabstand. Das Substrat 15 besteht in diesem Falle aus einem Isoliermaterial, beispielsweise aus einer thermoplastischen Folie, deren Dircke im Verhältnis zur Elektrode 10 übertrieben groß dargestellt ist. Das Substrat 15 besitzt auch hier eine zu beschichtende Oberfläche 15b. Das Substrat besitzt weiterhin eine der Elektrode 10 zugekehrte erste Oberfläche 15c, und der Abstand $s_2$ zwischen dieser Oberfläche 15c und der Elektrode 10 ist wiederum kleiner als der unter den vorgegebenen Verfahrensbedingungen sich einstellende Dunkelraumabstand. Der Abstand $s_1$ zwischen der zu behandelnden Oberfläche 15b und der gleichen Elektrode 10 ist in der Praxis nicht merklich verschieden von dem vorerwähnten Abstand $S_2$, weil die Dicke des Substrats 15, die der Differenz zwischen $S_1$ und $S_2$ entspricht, in Relation zu den übrigen Abmessungen vernachlässigbar ist. Die üblicherweise zu behandelnden thermoplastischen Folien haben Dicken zwischen 1 und 5 μm. In jedem Falle ist der Spalt 23, dessen Breite durch den Abstand $s_2$ definiert wird, so eng zu halten, daß in ihm keine Glimmentladung brennt. Es ist auch hier zu erkennen, daß die magnetische Falle so eingestellt ist, daß sie das Substrat durchdringt und über der der Elektrode abgewandten, zu beschichtenden Oberfläche 15b geschlossen ist, derart, daß sich das eingeschnürte Plasma auf der der Elektrode abgekehrten Seite des Substrats befindet.

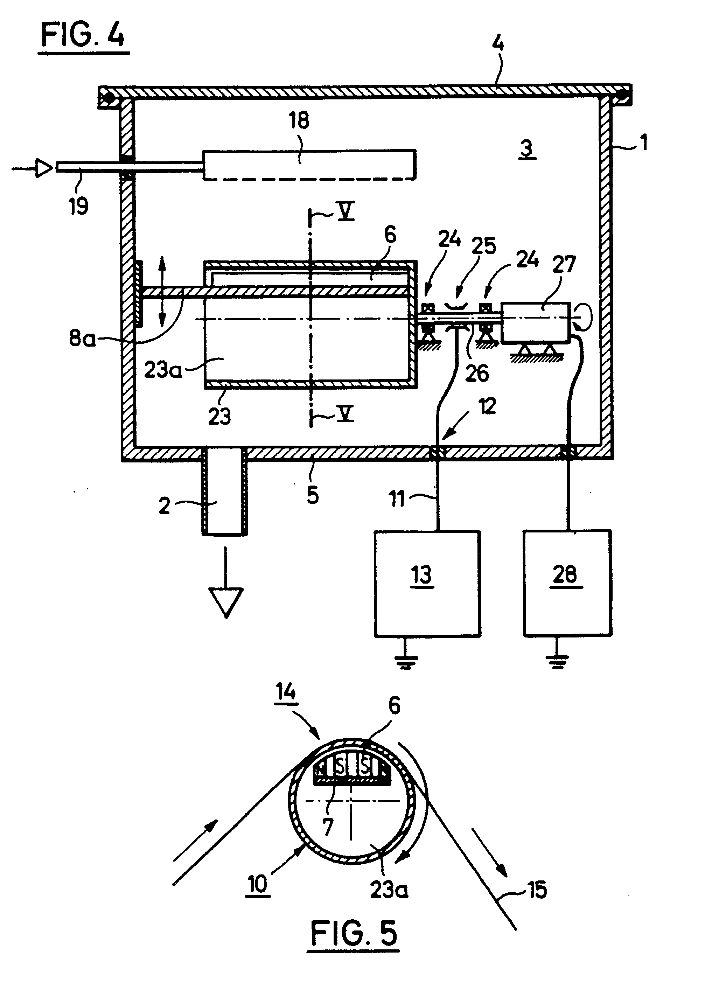

In Figur 4 sind gleiche Teile wie bisher mit gleichen Bezugszeichen versehen.

Die Haltevorrichtung 14 besteht im vorliegenden Fall aus einer hohlen Führungswalze 23, die gleichzeitig die Elektrode 10 ist, und in deren Innenraum 23a das Magnetsystem 6 untergebracht ist. Wie aus Figur 5 hervorgeht, liegen die nicht näher bezeichneten Polflächen des Magnetsystems 6 in einer Zylinderfläche, die möglichst nahe an der zylindrischen Innenfläche der Führungswalze 23 angeordnet ist. Über die Führungswalze 23 kann gemäß Figur 5 ein folienförmiges Substrat 15 geführt werden, was im Prinzip der Anordnung gemäß Figur 2 entspricht. Es ist weiterhin sogar möglich, die Führungswalze 23 nicht nur als Elektrode, sondern gleichzeitig auch als Substrat zu verwenden, d.h. die (auswechselbare) Führungswalze ist das Endprodukt und wird einer speziellen Oberflächenbeschichtung unterzogen.

Die Führungswälze 23 besitzt eine Welle 26, die in Drehlagern 24 gelagert und über einen Schleifkontakt 25 mit der Spannungsquelle 13 verbunden ist. Das jenseitige Ende der Welle 26 ist mit einem Antriebsmotor 27 verbunden, dessen Drehzahl über eine Antriebssteuerung 28 regelbar ist.

Das Verfahren und die Vorrichtung sind für eine ganze Reihe von reaktiven Beschichtungsverfahren geeignet. So können beispielsweise anorganische Schichten aus gasförmigen bzw. flüchtigen Verbindungen von Silizium, Germanium, Arsen, Bor, Aluminium, Titan, Phosphor und Gallium hergestellt werden. Es ist weiterhin möglich, polymere Schichten aus polymerisationsfähigen Monomeren herzustellen, beispielsweise Polymethylmethacrylat aus Methyl-Methacrylat. Weiterhin ist es möglich, amorphe Kohlenstoffschichten aus Kohlenwasserstoffverbindungen wie $C_2H_2$ oder $C_4H_{10}$ herzustellen.

Beispiele :

In einer Vorrichtung nach Figur 1 wurden Substrate aus Glas, Aluminium und Kunststoff in Platten- bzw. Folienform untergebracht. Über ein Dosierventil wurde Methyl-Methacrylat ($C_5H_8O_2$) mit 5 Volumensprozent Argonzusatz und einer Menge von 60 cm³/s in die Reaktionskammer eingeführt, wobei durch entsprechendes Abpumpen ein Prozeßdruck von 2,2 × $10^2$ mbar eingestellt wurde. Eine Magnetronkatode des Typs PK 500 (Hersteller : Leybold-Heraeus GmbH) wurde bei einer Elektrodenspannung von 100 V mit einer Leistung von 800 W beaufschlagt. Die gesamte Katodenfläche betrugt 450 cm². Die Niederschlagsrate betrugt 3 nm/s. Es ergaben sich Schichten aus plasmapolymerisiertem Methyl-Methacrylat, die transparent waren und einen Brechungsindex von 1,5 bis 1,6 aufwiesen. Durch Steigrung der elektrischen Leistung liessen sich Niederschlagsraten von mehr als 6 nm/s erreichen.

**Ansprüche**

1. Verfahren zum Beschichten von kontinuierlich über eine Elektrode bewegten Substraten durch Abscheidung von Verbindungen aus der Gasphase mittels einer durch die Elektrode erzeugten Plasmaentladung mit einer chemischen Reaktion, wobei auf der dem Substrat abgekehrten Seite der Elektrode ein Magnetsystem zur Erzeugung einer das Plasma einschnürenden magnetischen Falle angeordnet ist, **dadurch gekennzeichnet,** daß die zu behandelnde Oberfläche des Substrats in einem konstanten Abstand "$s_1$" von der Elektrode gehalten wird, der kleiner ist als der unter den vorgegebenen Verfahrensbedingungen sich einstellende Dunkelraumabstand, und daß die magnetische Falle so eingestellt wird, daß sie das Substrat durchdringt und über der zu beschichtenden Oberfläche des Substrats geschlossen ist, derart, daß die chemische Reaktion im eingeschnürten Plasma auf der zu beschichtenden Oberfläche des Substrats aufrechterhalten wird.

2. Verfahren nach Anspruch 1 zum Beschichten von über mindestens eine ortsfeste Elektrode bewegten Substraten, **dadurch gekennzeichnet,** daß die der Elektrode abgekehrte erste Oberfläche des Substrats in einem Abstand "$s_2$" zur Elektrode gehalten wird, der kleiner ist als der unter den vorgegebenen Verfahrensbedingungen gegebene Dunkelraumabstand, und daß die magnetische Falle so eingestellt wird, daß sie das Substrat durchdringt, und über der der Elektrode abgewandten zweiten Oberfläche des Substrats geschlossen ist, derart, daß die chemische Reaktion im eingeschnürten Plasma auf der der Elektrode abgekehrten Seite des Substrats aufrechterhalten wird.

3. Verfahren nach Anspruch 1 zum Beschichten von Substraten mit Polymerisaten, <u>dadurch gekennzeichnet,</u> daß man dem Plasma kontinuierlich polymerisationsfähige Substanzen zuführt.

4. Verfahren nach Anspruch 1, <u>dadurch gekennzeichnet,</u> daß die Elektrode auf negativem Potential gehalten wird.

5. Chemischer Reaktor zur Durchführung des Verfahrens nach Anspruch 2, mit einer evakuierbaren Reaktionskammer mit mindestens einer Zuführungseinrichtung für Reaktionskomponenten, mit einer Haltevorrichtung für mindestens ein Substrat, mit einer in der Nähe der Substratposition angeordneten Elektrode für die Erzeugung eines Plasmas und mit einem auf der der Substratposition gegenüberliegenden Seite der Elektrode angeordneten Magnetsystem mit Polflächen entgegengesetzter Polung zur Erzeugung einer von den Polflächen ausgehenden, in sich geschlossenen, die Elektrode durchdringenden magnetischen Falle, <u>dadurch gekennzeichnet,</u> daß die Haltevorrichtung (14) in einer solchen räumlichen Lage zur Elektrode (10) angeordnet ist, daß sich die der Elektrode (10) zugekehrte erste Oberfläche (15c) des Substrats (15) in einem Abstand "$s_2$" zur Elektrode befindet, der kleiner ist als der unter den vorgegebenen Verfahrensbedingungen gegebene Dunkelraumabstand von etwa 1-3 mm, und daß die magnetische Falle (21) so eingestellt ist, daß sie das Substrat (15) durchdringt und über der der Elektrode (10) abgewandten zweiten Oberfläche (15b) des Substrats geschlossen ist, derart, daß sich das eingeschnürte Plasma und die chemische Reaktionszone auf der der Elektrode abgekehrten Seite des Substrats befinden.

6. Vorrichtung nach Anspruch 6, <u>dadurch</u>

gekennzeichnet, daß die Haltevorrichtung (14) für das Substrat (15) aus mindestens einer Führungswalze (23) besteht, durch die das Substrat parallel zur Elektrode (10) über diese führbar ist.

7. Vorrichtung nach Anspruch 6, dadurch gekennzeichnet, daß die Haltevorrichtung (14) für das Substrat (15) aus einer hohlen Führungswalze (23) besteht, die gleichzeitig die Elektrode ist und in deren Hohlraum (23) das Magnetsystem (6) untergebracht ist.

## Revendications

1. Procédé de revêtement de substrats déplacés en continu au-dessus d'une électrode par dépôt de composés à partir de la phase gazeuse au moyen d'une décharge à plasma produite par l'électrode avec une réaction chimique, un système magnétique pour la production d'un piège magnétique confinant le plasma étant disposé du côté de l'électrode opposé au substrat, caractérisé en ce que la surface du substrat qui doit être traitée est maintenue à une distance constante "$s_1$" de l'électrode qui est plus petite que la distance de l'espace sombre qui s'établit dans les conditions prédéterminées du procédé, et en ce que le piège magnétique est disposé de telle façon qu'il traverse le substrat et qu'il soit fermé au-dessus de la surface du substrat qui doit être revêtue de telle façon que les réactions chimiques dans le plasma confiné soient maintenues sur la surface du substrat qui doit être revêtue.

2. Procédé selon la revendication 1, pour le revêtement de substrats déplacés au-dessus d'au moins une électrode fixe, caractérisé en ce que la première surface du substrat opposée à l'électrode est maintenue à une distance "$s_2$" de l'électrode qui est plus petite que la distance de l'espace sombre donnée dans les conditions prédéterminées du procédé, et en ce que le piège magnétique est disposé de telle façon qu'il traverse le substrat et qu'il soit fermé au-dessus de la deuxième surface du substrat opposée à l'électrode de telle façon que la réaction chimique dans le plasma confiné soit maintenue sur le côté du substrat opposé à l'électrode.

3. Procédé selon la revendication 1, pour revêtir des substrats avec des polymères, caractérisé en ce que l'on introduit en continu dans le plasma des substances polymérisables.

4. Procédé selon la revendication 1, caractérisé en ce que l'électrode est maintenue à un potentiel négatif.

5. Réacteur chimique pour la mise en oeuvre du procédé selon la revendication 2, avec une chambre de réaction susceptible d'être mise sous vide avec au moins un dispositif d'introduction pour les composants de la réaction, avec un dispositif de maintien pour au moins un substrat, avec une électrode disposée à proximité de la position du substrat pour la production d'un plasma et avec un système magnétique disposé du côté de l'électrode opposé à la position du substrat avec des surfaces polaires de polarité opposée pour la production d'un piège magnétique partant des surfaces polaires, fermé sur lui-même et traversant l'électrode, caractérisé en ce que le dispositif de maintien (14) est disposé en une position spatiale par rapport à l'électrode (10) telle que la première surface (15c) du substrat (15) tournée vers l'électrode (10) se trouve à une substance "$s_2$" de l'électrode qui est plus petite que la distance de l'espace sombre d'environ 1 à 3 mm donnée dans les conditions prédéterminées du procédé, et en ce que le piège magnétique (21) est disposé de telle façon qu'il traverse le substrat (15) et qu'il soit fermé au-dessus de la deuxième surface (15b) du substrat opposée à l'électrode (10) de telle façon que le plasma confiné et la zone de réaction chimique se trouvent du côté du substrat opposé à l'électrode.

6. Dispositif selon la revendication 6, caractérisé en ce que le dispositif de maintien (14) pour le substrat (15) consiste en au moins un cylindre de guidage (23) grâce auquel le substrat peut être conduit parallèlement à l'électrode (10) au-dessus de celle-ci.

7. Dispositif selon la revendication 6, caractérisé en ce que le dispositif de maintien (14) pour le substrat (15) consiste en un cylindre de guidage creux (23) qui constitue en même temps l'électrode et dans l'espace creux (23) duquel est disposé le système magnétique (6).

## Claims

1. Process for coating substrates which are continuously moved over an electrode, by precipitating compounds from the gas phase by means of a plasma discharge produced by the electrode, and by a chemical reaction, whereby a magnet system for generating a magnetic trap enclosing the plasma is placed on the side of the electrode which faces away from the substrate, characterised in that the surface of the substrate to be treated is maintained at a constant distance "$s_1$" from the electrode, which is less than the dark space distance obtaining under the stated process conditions, and that the magnetic trap is adjusted so that it penetrates the substrate and is completed above the surface of the substrate being coated in such a way that the chemical reaction in the enclosed plasma is maintained on the surface of the substrate being coated.

2. Process according to claim 1 for coating substrates which are moved over at least one fixed electrode, characterised in that the first surface of the substrate facing the electrode is held at a distance "$s_2$" from the electrode, which is less than the stated dark space distance of the specified process conditions, and if the magnetic trap is adjusted so that it passes through the substrate and is completed above the second surface of the substrate which faces away from the electrode, the chemical reaction in the enclosed plasma is maintained on the side of the substrate facing away from the electrode.

3. Process according to claim 1 for coating substrates with polymerides, characterised in that the plasma is continuously supplied with substances capable of being polymerized.

4. Process according to claim 1, characterised in that the electrode is held at a negative potential.

5. Chemical reactor for carrying out the process according to claim 2, with a vacuum reaction chamber with at least one feed system for the reaction components, a retaining device for at least one substrate, an electrode placed in the vicinity of the substrate position for generating a plasma, and a magnet system placed on the side of the electrode facing away from the substrate position, with pole faces of opposite polarity for generating a closed magnetic trap which extends from the pole faces and passes through the electrode, characterised in that the retaining device (14) is placed in such a position with respect to the electrode (10) so that the first surface (15c) of the substrate (15) facing the electrode (10) is at a distance "$s_2$" from the electrode, said distance being less than the dark space distance of approximately 1 to 3 mm which is stated in the specified process conditions, and that the magnetic trap (21) is adjusted so that it passes through the substrate (15) and is completed above the second surface (15b) of the substrate which faces away from the electrode (10) in such a way that the enclosed plasma and the chemical reaction zone are located on the side of the substrate facing away from the electrode.

6. Device according to claim 6, characterised in that the retaining device (14) for the substrate (15) consists of at least one guide roller (23) over which the substrate can be fed parallel to the electrode (10).

7. Device according to claim 6, characterised in that the retaining device (14) for the substrate (15) consists of a hollow guide roller (23) which is also the electrode and whose inner space (23a) houses the magnet system (6).

1/3

# FIG.1

FIG. 2

FIG. 3

## FIG. 4

## FIG. 5